Europäisches Patentamt

European Patent Office

Office européen des brevets

(11) Veröffentlichungsnummer: **0 253 002**
**A1**

## (12) EUROPÄISCHE PATENTANMELDUNG

(21) Anmeldenummer: **86109562.8**

(22) Anmeldetag: **12.07.86**

(51) Int. Cl.⁴: **G01J 5/08**

(43) Veröffentlichungstag der Anmeldung:
**20.01.88 Patentblatt 88/03**

(84) Benannte Vertragsstaaten:
**AT BE CH DE FR GB IT LI LU NL SE**

(71) Anmelder: **Pusch, Günter, Dr.-Ing.**
**Bannholzweg 12 Postfach 49**
**D-6903 Neckargemünd(DE)**

(72) Erfinder: **Pusch, Günter, Dr.-Ing.**
**Bannholzweg 12 Postfach 49**
**D-6903 Neckargemünd(DE)**

(74) Vertreter: **Paul, Dieter-Alfred, Dipl.-Ing.**
**Fichtestrasse 18**
**D-4040 Neuss 1(DE)**

(54) Vorrichtung zur Erkennung thermischer Kontraste.

(57) Eine Vorrichtung zur Erkennung thermischer Kontraste im Temperaturbereich um 300 K und innerhalb zumindest eines atmosphärischen Fensters weist einen IR-Detektor (1) mit wenigstens einem Detektorelement (8) und einem davor angeordneten Reflexionsfilter (9) auf, dessen Durchlässigkeit dem Spektralbereich guter Durchlässigkeit im betreffenden atmosphärischen Fenster entspricht.

Damit der Reflexionsfilter (9) in zuverlässig reproduzierender Weise und mit vergleichsweise einfachen Mitteln hergestellt und gleichzeitig ein Übersprechen von Signalen bei einer Reihe von Detektorelementen (8) vermieden werden kann, ist der Reflexionsfilter (9) an dem bzw. den Detektorelement(en) (8) direkt anliegend angebracht, vorzugsweise aufgedampft.

Fig. 2

EP 0 253 002 A1

## Vorrichtung zur Erkennung thermischer Kontraste

Die Erfindung betrifft eine Vorrichtung zur Erkennung thermischer Kontraste im Temperaturbereich um 300 K und innerhalb zumindest eines atmosphärischen Fensters, mit einem IR-Detektor mit wenigstens einem Detektorelement und einem davor angeordneten Reflexionsfilter, dessen Durchlaßbereich dem Spektralbereich guter Durchlässigkeit im betreffenden atmosphärischen Fenster entspricht.

Eine solche Vorrichtung ist in der CH-PS 5-64 764 bzw. DE-PS 22 33 870 und 22 65 465 beschrieben. Bei dieser Vorrichtung befindet sich im Zentrum einer sphärischen Lochblende und im Brennpunkt eines Objektivs ein Infrarot-Detektor mit einem bzw. einer Reihe von Detektorelement(en). Entsprechende Detektoren sind beispielsweise aus der DE-OS 25 53 378 bekannt.

Zwischen Detektor und Objektiv ist ein Reflexionsfilter angeordnet, dessen Durchlaßbereich auf einen Teilspektralbereich des atmosphärischen Fensters II - es erstreckt sich etwa zwischen 3 bis 5,3 $\mu$m Wellenlänge - begrenzt ist, nämlich auf den Bereich zwischen 3,3 und 4,2 $\mu$m Wellenlänge. Hierdurch wurde der Erkenntnis Rechnung getragen, daß die Durchlässigkeit der Atmosphäre bei etwa 4,2 $\mu$m, bedingt durch den Gehalt an Kohlendioxid und Wasserdampf, einen starken Einbruch hat, wodurch Störstrahlungen entstehen, die die Kontrastempfindlichkeit stark beeinträchtigen. Durch die Ausgrenzung dieses Bereichs mit Hilfe des Reflexionsfilters konnte somit eine erhebliche Verbesserung der Kontrastempfindlichkeit erzielt werden.

Der vorbekannte Reflexionsfilter besteht aus einem IR-transparenten Körper, auf dessen konkave Seite mehrere Schichten eines hierfür geeigneten Materials aufgedampft sind. Materialwahl und Schichtdicke können dabei so gewählt werden, daß der Durchlaßbereich entsprechend den jeweiligen Anforderungen eingestellt und mit hoher Flankensteilheit abgegrenzt werden kann. Es bestand deshalb auch die Möglichkeit, bei dem Gerät der vorbekannten Art die Flankensteilheit entsprechend der Abfallcharakteristik des ausgewählten Teilspektralbereichs auszubilden. Die Herstellung solcher Reflexionsfilter gehört zum allgemeinen Stand der Technik und kann beispielsweise der Literatur "Wolfe, The Infrared Handbook, 1978, S. 7-103 ff" entnommen werden.

Soweit die vorbekannte Vorrichtung mehrere Detektorelemente enthält, werden die Störstrahlungen innerhalb des Gehäuses dadurch vermieden, daß die Lochblende derart symmetrisch zum sphärischen Mittelpunkt des Reflexionsfilters justiert wird, daß sich die jeweils symmetrisch zum Mittelpunkt liegenden Detektorelemente im Sperrbereich des Reflexionsfilters gegenseitig abbilden. Diese Maßnahme wie auch die Maßnahme, überhaupt einen Reflexionsfilter zu verwenden, führten dazu, daß Kontrastminderungen infolge Störstrahlungen weitestgehend vermieden werden.

Es hat sich jedoch gezeigt, daß die Herstellung des Reflexionsfilters außerordentlich schwierig ist. Bei dem technisch notwendigen kleinen Abstand zwischen Reflexionsfilter und Detektorelement(en) müssen die Filterradien sehr klein sein, und zwar im Bereich weniger Millimeter. Es bereitet große Probleme und gelingt häufig nicht, die Schichten in der hierfür erforderlichen Gleichmäßigkeit aufzudampfen.

Es wurden deshalb Überlegungen und Versuche angestellt, den interessierenden Teilspektralbereich durch Materialwahl und Mischungsverhältnis des für die Herstellung der Detektorelemente verwendeten Detektormaterials einzugrenzen. Dies gestaltete sich jedoch zumindest hinsichtlich des Detektormaterials CdHg:HgTe als fertigungsmäßig ebenso schwierig, da es hierzu der genauen Einstellung des Mischungsverhältnisses und der stöchiometrischen Werte bedarf. Dies ist nur mit außerordentlich hohem Aufwand möglich.

Bei der Ausführungsform der vorbekannten Vorrichtung mit einer Reihe von Detektorelementen wurde zudem festgestellt, daß durch die spiegelnde Abbildung der Detektorelemente aufeinander im Sperrbereich des Reflexionsfilters ein Übersprechen der Signale auftreten kann. Dies führt zu entsprechenden Verfälschungen.

Der Erfindung liegt die Aufgabe zugrunde, eine Vorrichtung der eingangs genannten Art so auszubilden, daß der Reflexionsfilter mit jeweils gewünschten Eigenschaften in zuverlässig reproduzierbarer Weise und kostengünstig hergestellt werden kann sowie gleichzeitig ein Übersprechen von Signalen bei Verwendung einer Reihe von Detektorelementen vermieden wird.

Diese Aufgabe wird erfindungsgemäß dadurch gelöst, daß der Reflexionsfilter an dem bzw. den Detektorelement(en) direkt anliegend angebracht ist, vorzugsweise auf diesen bzw. diese aufgedampft ist.

Erfindungsgemäß steht also der Reflexionsfilter in direktem Kontakt zu dem IR-Detektor. Da dessen Detektorelemente ebene Flächen darstellen, gestaltet sich das Aufbringen, insbesondere das Bedampfen als vergleichsweise einfach. Der Reflexionsfilter läßt sich mit hoher Genauigkeit auftragen, so daß die jeweils gewünschte Charakteristik mit großer Zuverlässigkeit hergestellt werden kann. Dabei besteht die Möglichkeit, eine Vielzahl von IR-Detektoren in einem Bedampfungsvorgang mit dem Reflexionsfilter zu versehen.

Es besteht somit auch nicht mehr die Notwendigkeit, das Mischungsverhältnis der Detektormaterialien genau einzustellen. Die Selektion kann allein durch den Reflexionsfilter durchgeführt werden.

Dabei ist von besonderem Vorteil, daß bei einem IR-Detektor mit mehreren Detektorelementen ein Übersprechen der Signale zwischen den Detektorelementen nicht mehr auftreten kann, ohne daß hierfür Beeinträchtigungen durch Störstrahlungen im Sperrbereich in Kauf genommen werden müssen. Ein weiterer Vorteil besteht darin, daß der Reflexionsfilter gleichzeitig eine Schutzschicht darstellt, das Aufbringen einer besonderen Schutzschicht entfallen kann.

Wie vorstehend dargelegt, bietet es sich an, den Reflexionsfilter direkt auf das bzw. die Detektorelement(e) aufzudampfen. Es besteht jedoch auch die Möglichkeit, den Reflexionsfilter auf einen flachen IR-transparenten Körper aufzubringen, und zwar auch aufzudampfen, und dann diesen Körper mit dem Reflexionsfilter auf das bzw. die Detektorelement(e) direkt aufzulegen. Auch in diesem Fall ist die Herstellung des Reflexionsfilters vergleichsweise einfach.

Die Erfindung ist nicht auf die Ausbildung des Reflexionsfilters für den in der CH-PS 5 64 764 erwähnten Teilspektralbereich des atmosphärischen Fensters II beschränkt. Die erfindungsgemäße Ausbildung eignet sich auch für andere Spektralbereiche, und zwar auch für die im Fenster III.

In der Regel wird der Reflexionsfilter zur Erzielung der jeweils gewünschten Charakteristik aus mehreren Schichten aufgebaut sein, wobei diese Schichten meist λ/4-Schichten sind. Der jeweilige Aufbau kann der Fachliteratur entnommen werden. Bei der erfindungsgemäßen Ausbildung besteht die jedoch die Möglichkeit und wird empfohlen, daß der Brechungsindex bzw. die Brechungsindizes der Schicht(en) so gewählt ist bzw. sind, daß das bzw. die Detektorelement(e) die einfallenden IR-Strahlen möglichst vollständig absorbiert bzw. absorbieren. Auf diese Weise wird ein maximaler Quantenwirkungsgrad erreicht.

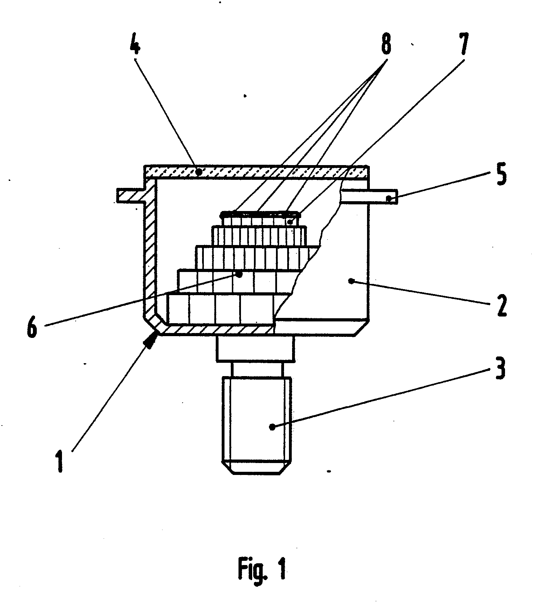

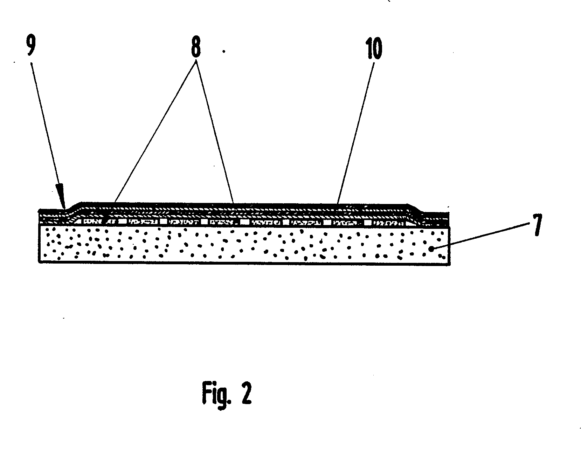

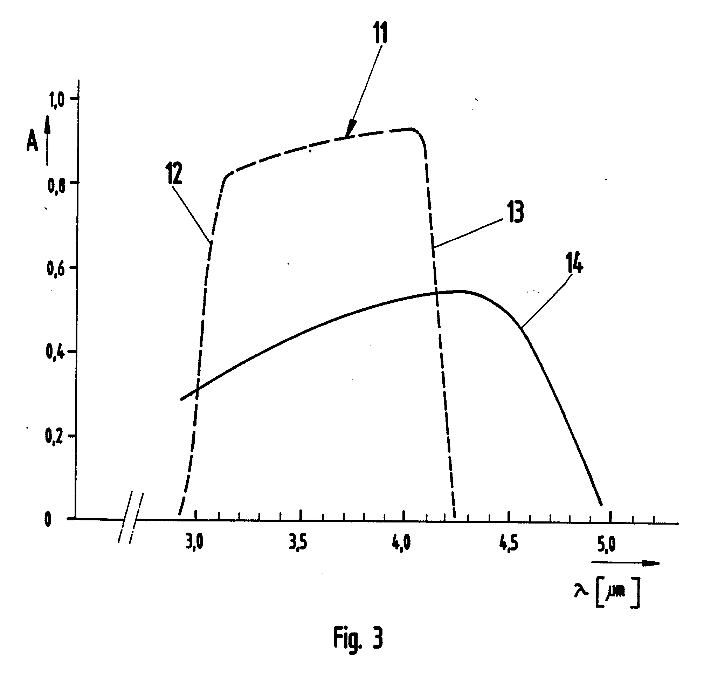

In der Zeichnung ist die Erfindung an Hand eines Ausführungsbeispiels näher veranschaulicht. Es zeigen:

Figur (1) einen Teilquerschnitt durch einen IR-Detektor;

Figur (2) eine vergrößerte Darstellung der Detektorelemente des IR-Detektors gemäß Figur (1) und

Figur (3) eine Grafik zur Darstellung der Empfangsamplitude über die Wellenlänge bezüglich des Reflexionsfilters und der Detektorelemente des IR-Detektors gemäß den Figuren (1) und (2).

Der in Figur (1) dargestellte IR-Detektor (1) weist ein topfförmiges Gehäuse (2) auf, an dessen Boden ein Gewindezapfen (3) angesetzt ist, der zur Befestigung an einer entsprechenden Vorrichtung bestimmt ist. Das Gehäuse (2) wird obenseitig mit einer planen Saphirscheibe (4) abgeschlossen. In diesem Bereich ist zusätzlich auch noch ein Flansch (5) angeformt. Vor der Saphirscheibe (4) ist noch eine Optik angeordnet, die hier jedoch weggelassen ist.

In dem Gehäuse (2) befindet sich ein Kühlkörper (6), dessen nähere Ausgestaltung dem Stand der Technik entnommen werden kann und nicht Gegenstand der vorliegenden Erfindung ist. Es wird deshalb auf eine Beschreibung im Detail verzichtet. Auf einer planen Grundplatte (7) ist eine Reihe von Detektorelementen - beispielhaft mit (8) bezeichnet - aufgebracht, die ebenfalls in an sich bekannter Weise gestaltet sind. Im vorliegenden Beispiel bestehen sie aus einer Kristallmischung CdHg:HgTe, da diese Detektorelemente (8) - wie Figur (3) zeigen wird - für den Empfang im atmosphärischen Fenster II bestimmt sind.

Auf die Detektorelemente (8) ist ein Reflexionsfilter (9) aufgedampft, was in Figur (1) nicht näher dargestellt ist, sich aber aus der vergrößerten Darstellung in Figur (2) ersehen läßt. Dabei sind die einzelnen Schichten - beispielhaft mit (10) bezeichnet -, was ihre Dicke angeht, aus zeichnerischen Gründen nochmals stark vergrößert. Außerdem sind die Schichten (10) - ebenfalls aus zeichnerischen Gründen - gerade durchgezogen dargestellt. Tatsächlich liegen sie in den Zwischenräumen zwischen den Detektorelementen(8) an der Grundplatte (7) an.

Es sind hier insgesamt nur vier Schichten eingezeichnet. Es können jedoch zur Erreichung hoher Flankensteilheit auch zehn und mehr Schichten vorgesehen werden, wobei die Dicke der Schichten jeweils im λ/4-Bereich liegen. Durch Verwendung entsprechender Materialien und damit Brechungsindizes kann erreicht werden, daß die Detektorelemente (8) die einfallenden IR-Strahlen praktisch vollständig absorbieren.

Die Grafik in Figur (3) zeigt durch die in gestrichelter Darstellung gehaltene Kurve (11) die Durchlaßcharakteristik des Reflexionsfilters (9). Es ist zu sehen, daß der Reflexionsfilter (9) sowohl auf der kurzwelligen Seite (12) als auch auf der langwelligen Seite (13) eine hohe Flankensteilheit hat, was insbesondere auf der langwelligen Seite (13) wegen des abrupten Durchlässigkeitsabfalls in der Atmosphäre bei 4,2 μm Wellenlänge wichtig ist. Im Bereich zwischen 4,1 und 4,2 μm fällt die Durchlässigkeit des Reflexionsfilters (9) von 90% auf 10% ab. Aufgrund der hohen Flankensteilheit kann ansonsten der Spektralbereich hoher Durchlässigkeit im atmosphärischen Fenster II fast vollständig ausgenutzt werden, und zwar von 3,2 bis 4,1 μm Wellenlänge mit einer hohen, zwischen 80% und 90% liegenden Empfangsamplitude. Aufgrund der erfindungsgemäßen Anordnung des Reflexionsfilters (9) läßt sich diese Charakteristik mit hoher Reproduzierbarkeit und vergleichsweise geringen Kosten herstellen.

Die durchgezogene Kurve (14) stellt die Empfangsamplitude der Detektorelemente (8) dar. Aufgrund der hohen Reflexion des Detektormaterials ist diese Amplitude wesentlich geringer als die des Reflexionsfilters (9). Es ist zu erkennen, daß die Kurve (14) sich erheblich weiter erstreckt als der Durchlässigkeitsbereich des Reflexionsfilters (9) geht, was auf nicht genaue Einhaltung des Mischungsverhältnisses der Detektormaterialien schließen läßt. Darauf kommt es jedoch wegen der genau einstellbaren Selektivität des Reflexionsfilters (9) nicht mehr an.

Im übrigen kann die Empfangsamplitude bis in den Bereich derjenigen des Reflexionsfilters gesteigert werden, wenn die Brechungsindizes der Schichten (10) so gewählt werden, daß die Detektorelemente (8) die IR-Strahlen möglichst vollständig absorbieren.

## Ansprüche

1. Vorrichtung zur Erkennung thermischer Kontraste im Temperaturbereich um 300 K und innerhalb zumindest eines atmosphärischen Fensters, mit einem IR-Detektor (1) mit wenigstens einem Detektorelement (8) und einem davor angeordneten Reflexionsfilter (9), dessen Durchlaßbereich dem Spektralbereich guter Durchläsigkeit im betreffenden atmosphärischen Fenster entspricht, dadurch gekennzeichnet, daß der Reflexionsfilter (9) an dem bzw. den Detektorelement(en) (8) direkt anliegend angebracht ist.

2. Vorrichtung nach Anspruch 1, dadurch gekennzeichnet, daß der Reflexionsfilter (9) auf den bzw. die Detektorelement(e) (8) aufgedampft ist.

3. Vorrichtung nach Anspruch 1 oder 2, dadurch gekennzeichnet, daß der Reflexionsfilter (9) aus mehreren Schichten (10) aufgebaut ist.

4. Vorrichtung nach Anspruch 3, dadurch gekennzeichnet, daß der Brechungsindex bzw. die Brechungsindizes der Schicht(en) (10) so gewählt ist bzw. sind, daß das bzw. die Detektorelement(e) (8) die einfallenden IR-Strahlen möglichst vollständig absorbiert bzw. absorbieren.

Fig. 1

Fig. 2

Fig. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y,D | US-A-3 875 408 (G. PUSCH)<br>* Spalten 2,3 *<br><br>--- | 1 | G 01 J 5/08 |
| Y | US-A-4 158 133 (W. SPAETH et al.)<br>* Spalten 1-5 *<br><br>--- | 1-4 | |
| Y | PATENTS ABSTRACTS OF JAPAN, Band 9, Nr. 109 (P-355)[1832], 14. Mai 1985; & JP-A-59 230 120 (KOGYO GIJUTSUIN (JAPAN)) 24-12-1984<br>* Insgesamt *<br><br>--- | 1-4 | |
| Y | PATENTS ABSTRACTS OF JAPAN, Band 6, Nr. 194 (E-134)[1072], 2. Oktober 1982; & JP-A-57 104 275 (NIPPON DENKI K.K.) 29-06-1982<br>* Insgesamt *<br><br>----- | 1-4 | **RECHERCHIERTE SACHGEBIETE (Int. Cl.4)**<br><br>G 01 J 5/08<br>H 01 L 31/02 |

Der vorliegende Recherchenbericht wurde für alle Patentansprüche erstellt.

| Recherchenort | Abschlußdatum der Recherche | Prüfer |
|---|---|---|
| DEN HAAG | 16-03-1987 | BOEHM CH.E.D. |